# FASCICULE DE BREVET EUROPEEN

(11) **EP 2 051 574 B1**
(45) Date de publication et mention de la délivrance du brevet: **04.12.2013**
(21) Numéro de dépôt: 08166183.7
(22) Date de dépôt: 09.10.2008
(51) Int. Cl.: H05K 9/00

(54) **Dispositif d'alimentation électrique pour une lampe à décharge comportant un blindage de ballast**
Vorrichtung zur Stromversorgung einer Leuchtstofflampe, die eine Abschirmung des Vorschaltgeräts umfasst
Power supply device for a discharge lamp comprising a ballast shield

(30) Priorité: 19.10.2007 FR 0707349
(43) Date de publication de la demande: 22.04.2009
(73) Titulaire: VALEO VISION, 93012 Bobigny (FR)
(72) Inventeur: Clavier, Philippe, 77600 Bussy Saint Georges (FR)

(56) Documents cités:
- FR-A- 727 040
- FR-A- 2 700 914
- JP-A- 2000 164 379
- JP-A- 2000 173 311
- US-A1- 2002 155 738

## Description

L'invention concerne un dispositif d'alimentation d'une lampe à décharge d'un projecteur de véhicule automobile.

L'invention concerne plus particulièrement un dispositif d'alimentation électrique pour une lampe à décharge d'un projecteur de véhicule automobile qui comporte :
- une source de courant électrique ;
- un module électronique de conversion du courant électrique de source en courant électrique d'alimentation de la lampe à décharge ;
- un boîtier qui renferme ledit module électronique et qui est réalisé en / comporte un matériau conducteur d'électricité de manière à former un blindage électromagnétique, notamment pour atténuer l'intensité d'un rayonnement électromagnétique émis par le module électronique ;
- un faisceau de connexion électrique qui est destiné à raccorder électriquement le module électronique de conversion avec la lampe à décharge ;
- une enveloppe réalisée en / comportant un matériau conducteur d'électricité qui entoure le faisceau de connexion de manière à former un blindage électromagnétique , notamment pour atténuer l'intensité d'un rayonnement électromagnétique émis par le faisceau de connexion ;
- le boîtier et l'enveloppe étant raccordés électriquement à un potentiel électrique commun de référence.

Dans l'industrie automobile, on utilise de plus en plus de projecteurs équipés de lampes à décharge, telles que les lampes au xénon, notamment pour leur rendement lumineux et pour leur longévité.

Ce type de lampe nécessite une alimentation en courant électrique alternatif à haute tension. Pour commander l'alimentation en courant électrique de la lampe, le projecteur comporte un dispositif d'alimentation électrique qui est équipé d'un module électronique de conversion, désigné habituellement "ballast", qui fournit à partir d'une tension de batterie du véhicule automobile des tensions alternatives élevées qui sont adaptées au type de lampe à décharge utilisée.

Le document JP 2000 173 311 divulgue un tel dispositif d'alimentation pour une lampe à décharge.

Les lampes à décharges peuvent émettre une grande quantité de rayonnements électromagnétiques dont l'effet est indésirable à la fois sur la sûreté de fonctionnement des autres circuits électroniques du véhicule et sur l'environnement radioélectrique dans lequel évolue le véhicule.

Pour remédier à cet inconvénient, il est connu de prendre plusieurs mesures dites "CEM", acronyme signifiant "Compatibilité ElectroMagnétique", séparément ou en combinaison selon les circonstances, lors de la conception du dispositif d'alimentation électrique de la lampe à décharge du projecteur.

Selon une première mesure, il est connu que les rayonnements électromagnétiques sont majoritairement émis par les connecteurs, par les faisceaux de connexion dont la longueur peut dans certains cas être élevés, ainsi que par certains appareillages électronique tel que le ballast. Cette première mesure pour réduire les émissions de rayonnements électromagnétiques consiste, ainsi qu'il est connu, à exécuter un blindage du faisceau d'alimentation de la lampe électrique et du ballast ainsi que, le cas échéant, de ses connecteurs.

Selon une seconde mesure, les blindages de la lampe, du ballast et du ou des faisceaux d'alimentation doivent être connectés à un potentiel électrique commun de référence afin que les divers blindages ne puissent pas varier en tension lors de l'utilisation et ainsi se transformer en structures rayonnantes parasites.

Le problème à la base de l'invention consiste à assurer que le blindage du faisceau de connexion du ballast à la lampe à décharge soit correctement relié au potentiel de référence afin de respecter les contraintes liées aux normes électromagnétiques.

Il est connu de relier électriquement le potentiel de référence au boîtier du ballast, puis de connecter le blindage du faisceau de connexion en série sur le blindage du ballast.

Cependant, on a constaté que, dans certaines configurations, une telle interconnexion ne permettait pas d'atténuer de manière satisfaisante les rayonnements électromagnétiques parasites.

Pour résoudre notamment ce problème, l'invention propose un dispositif d'alimentation électrique du type décrit précédemment, de sorte que le boîtier et l'enveloppe soient raccordés en parallèle audit potentiel électrique commun de référence.

Selon d'autres caractéristiques de l'invention :
- l'enveloppe est raccordée au potentiel électrique commun par l'intermédiaire d'un élément de contact réalisé en un matériau conducteur d'électricité présentant une meilleure conductivité électrique que le matériau utilisé pour réaliser le boîtier ;
- l'élément de contact est réalisé en un matériau comportant du cuivre ;
- le boîtier comporte des premiers moyens de connexion dans lesquels un premier connecteur réciproque relié électriquement au potentiel de référence est destiné à venir s'engager mécaniquement dans une position connectée, et le boîtier comporte des deuxièmes moyens de connexion dans lesquels un deuxième connecteur réciproque du faisceau de connexion est destiné à venir s'engager mécaniquement dans une position connectée, le deuxième connecteur réciproque étant entouré par l'enveloppe de blindage du faisceau de connexion, les premiers moyens de connexion étant agencés de manière adjacente aux deuxièmes moyens de connexion, et l'élément de contact étant agencé de manière à relier électriquement le potentiel commun de référence à l'enveloppe lorsque les premier et deuxième connecteurs réciproques occupent simultanément leur position connectée ;
- les premiers et deuxièmes moyens de connexion comportent un bloc commun de connexion mécanique qui est agencé dans une ouverture du boîtier, l'élément de contact étant porté par le bloc de connexion ;
- le bloc de connexion comporte une cloison mitoyenne qui sépare les premiers moyens de connexion des deuxièmes moyens de connexion, l'élément de contact étant formé par un cavalier qui chevauche la cloison mitoyenne ;
- le bloc de connexion est entouré d'un blindage électromagnétique qui est réalisé venu de matière avec l'élément de contact de manière en empêcher des fuites de rayonnement électromagnétique par l'ouverture du boîtier ;
- les premiers moyens de connexion comprennent une liaison électrique avec au moins deux branches de connexion du module électronique de conversion, reliées électriquement entre elles, le premier connecteur réciproque relié électriquement au potentiel de référence étant destiné à venir s'engager mécaniquement dans une position connectée à l'une de ces branches, et l'élément de contact étant destiné à s'engager mécaniquement et en contact électrique avec l'autre branche de connexion ; préférentiellement, la liaison électrique est une piste électrique d'une carte de circuit imprimé du module électronique de conversion et est en forme de fourche, chaque branche de la fourche constituant une branche de connexion du module électronique de conversion ;
- le bloc de connexion comporte une cloison mitoyenne qui sépare les premiers moyens de connexion des deuxièmes moyens de connexion, l'élément de contact traversant la cloison mitoyenne ;
- l'élément de contact est porté par l'un des premier ou deuxième connecteurs réciproques.

D'autres caractéristiques et avantages apparaîtront à la lecture de la description détaillée qui va suivre pour la compréhension de laquelle on se reportera aux dessins annexés parmi lesquels :
- la figure 1 est une vue schématique qui représente un projecteur de véhicule automobile comportant une lampe à décharge alimentée par un dispositif d'alimentation réalisé selon les enseignements de l'invention ;
- la figure 2 est une vue schématique de détail qui représente un module électronique de conversion ou ballast du dispositif d'alimentation qui est enfermé dans un boîtier blindé et qui est connecté à la batterie, d'une part, et à un faisceau électrique blindé d'autre part ;
- la figure 3 est une vue en perspective éclatée qui représente un bloc de connexion mécanique du module électronique de conversion qui est réalisé selon un premier mode de réalisation de l'invention ;
- la figure 4 est une vue en perspective qui représente le bloc de connexion mécanique de la figure 3 assemblé ;
- la figure 5 est une vue en coupe longitudinale selon le plan de coupe 5-5 de la figure 4 qui représente des lamelles de contact d'un élément de contact avec une plage de contact reliée à la borne négative de la batterie du véhicule automobile ;
- la figure 6 est une vue en coupe horizontale qui représente le bloc de connexion mécanique qui est réalisé selon un deuxième mode de réalisation de l'invention et dans lequel les deux connecteurs réciproques du faisceau de connexion et d'alimentation sont en position connectée ;
- la figure 7 est une vue en coupe horizontale qui représente un quatrième mode de réalisation de l'invention dans lequel le bloc de connexion mécanique est agencé sur la carte à circuit imprimé.

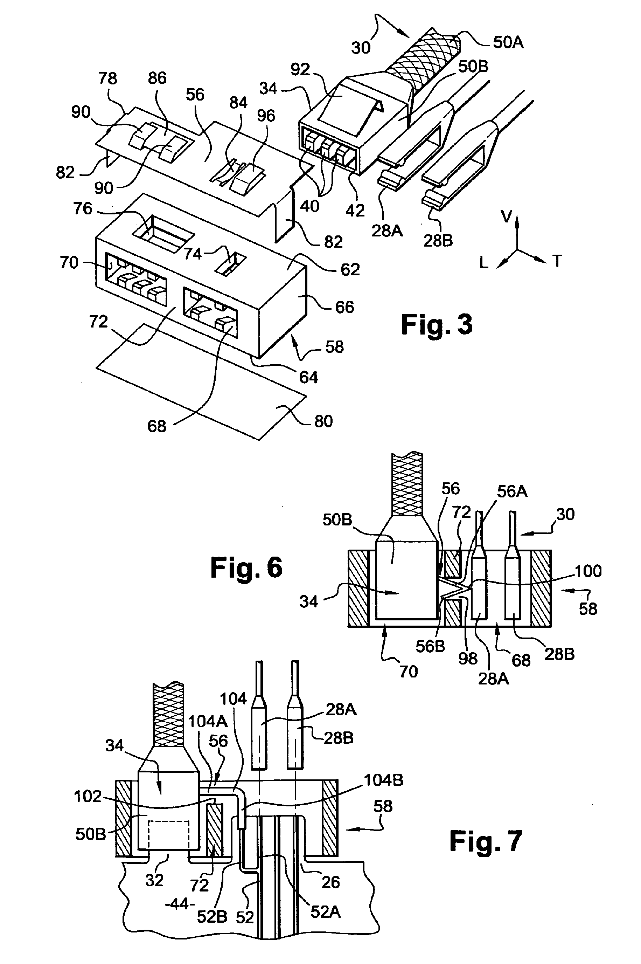

Dans la description qui va suivre, on adoptera à titre non limitatif des orientations longitudinale dirigée d'arrière en avant, verticale dirigée de bas en haut, et transversale dirigée de gauche à droite, qui sont indiquées par le trièdre "L,V,T" de la figure 3.

Par la suite, des éléments ayant des fonctions identiques, analogues ou similaires seront indiqués par des mêmes numéros de référence.

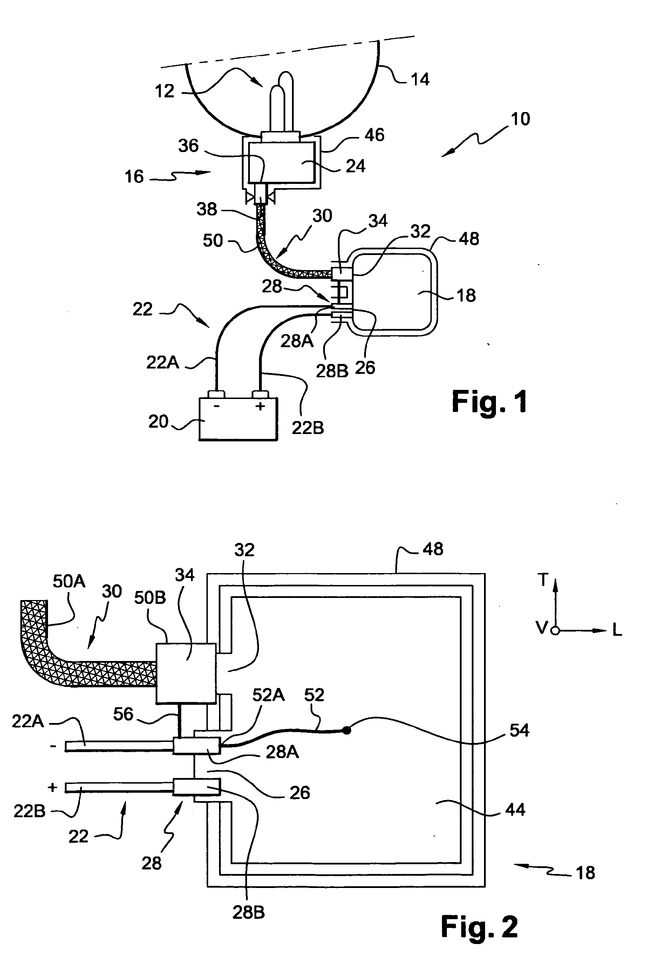

On a représenté à la figure 1 un projecteur 10 de véhicule automobile qui comporte une lampe à décharge 12 qui est agencée dans un réflecteur 14. La lampe à décharge 12 est ici une ampoule remplie d'un gaz tel que du xénon à une pression élevée, de sels métalliques et d'halogénures à l'état solide.

La lampe à décharge 12 comporte des moyens (non représentés) pour produire dans le gaz sous pression un arc électrique pour produire de la lumière. Les moyens pour produire l'arc électrique sont alimentés en électricité par un dispositif 16 d'alimentation électrique.

Le dispositif d'alimentation 16 comporte un module électronique de conversion 18, qui sera désigné par le terme "ballast" par la suite selon la dénomination couramment employée, qui est alimenté par une source de courant électrique 20 de tension continue par l'intermédiaire d'un premier faisceau électrique 22 d'alimentation du ballast 18.

La source de courant électrique 20 continu est formée par une batterie 20 du véhicule automobile qui comporte une borne positive et une borne négative, désignées respectivement par les symboles "+" et "-" à la figure 1 .

Le ballast 18 comporte plus particulièrement des premiers moyens de connexion d'entrée 26 dans lesquels un premier connecteur réciproque d'extrémité 28, dit "d'entrée", du faisceau d'alimentation 22 est engagé mécaniquement dans une position connectée électriquement.

Le faisceau d'alimentation 22 est formé de deux fils conducteurs isolés 22A, 22B qui comportent chacun une première extrémité reliée électriquement à une borne associée de la batterie 20 et une deuxième extrémité équipée d'une fiche 28A, 28B en forme de pince formant le premier connecteur réciproque d'entrée 28, comme représenté à la figure 3.

Le premier connecteur réciproque d'entrée 28 comporte ainsi une première fiche négative 28A reliée électriquement à la borne négative et une deuxième fiche positive 28B reliée électriquement à la borne positive.

Le module électronique de conversion 18 est destiné à convertir le courant électrique de tension continue de la batterie de source 20 en un courant électrique de tension alternative propre à alimenter la lampe à décharge 12 par l'intermédiaire d'un deuxième faisceau électrique de connexion 30.

Le dispositif d'alimentation 16 est aussi équipé d'un module d'amorçage haute tension 24 qui est interposé dans le circuit électrique entre le ballast 18 et la lampe à décharge 12. Dans l'exemple représenté à la figure 1, la lampe à décharge 12 et le module d'amorçage 24 forment un ensemble compact.

Le ballast 18 comporte ainsi des deuxième moyens de connexion électrique de sortie 32 dans lesquels un premier connecteur réciproque de sortie 34 du faisceau de connexion 30 est engagé mécaniquement dans une position connectée électriquement.

Le module d'amorçage 24 comporte aussi des moyens de connexion 36 qui sont destinés à être connectés électriquement avec un deuxième connecteur réciproque 38 d'extrémité opposée du faisceau de connexion 30.

Le faisceau de connexion 30 comporte ainsi un premier connecteur 34 d'extrémité de sortie et un deuxième connecteur 38 d'extrémité d'amorçage.

Comme illustré à la figure 3, le connecteur réciproque de sortie 34 comporte plus particulièrement une pluralité de fiches 40 d'apparence analogue à celles des fiches 28A, 28B du faisceau d'alimentation 22. Les fiches 40 du connecteur réciproque de sortie sont reliées électriquement à chacun des fils conducteurs constituant le faisceau de connexion 30. Les fiches 40 du connecteur réciproque de sortie 34 sont rangées transversalement dans un support 42 pavé creux du connecteur réciproque de sortie 34 qui est ouvert à une face d'extrémité avant.

De manière connue et comme représenté à la figure 2, le ballast 18 comporte une carte à circuit imprimé 44 rectangulaire qui s'étend horizontalement.

Les premiers moyens de connexion d'entrée 26 et de sortie 32 sont agencés sur un bord transversal d'extrémité arrière de la carte à circuit imprimé 44.

Ainsi, les premiers moyens de connexion d'entrée 26 du ballast 18 comportent une portion d'entrée du bord transversal arrière de la carte à circuit imprimé 44 sur lequel débouchent deux terminaisons de pistes d'entrée destinées à être connectées électriquement respectivement à la fiche négative 28A et à la fiche positive 28B du connecteur réciproque d'entrée 28.

Les deuxièmes moyens de connexion de sortie 32 comportent aussi une portion de sortie du bord transversal arrière de la carte à circuit imprimé 44 sur lequel débouche des terminaisons pistes de sortie dont chacune est destinée à être connectée électriquement à une fiche 40 associée du connecteur réciproque de sortie 34.

Chaque connecteur réciproque 28, 34 est ainsi destiné à être agencé, par coulissement longitudinal vers l'avant, dans sa position connectée dans laquelle chaque fiche 28A, 28B, 40 est en contact électrique avec la terminaison de piste associée.

Dans l'exemple représenté, les fiches 28A, 28B, 40 des connecteurs réciproques 28, 34 dans leur position connectée ont une forme de pince qui est destinées à chevaucher et à pincer élastiquement le bord de la carte à circuit imprimé 44.

Lors du fonctionnement du projecteur 10, la lampe à décharge 12, le faisceau de connexion 30 et le ballast 18 émettent un rayonnement électromagnétique qui est susceptible de parasiter et de perturber le fonctionnement d'autres appareils électriques présents dans le véhicule automobile.

Pour atténuer, voire éliminer totalement, au moins certaines fréquences de ces rayonnements électromagnétiques parasites, il est connu d'équiper le dispositif d'alimentation 16 de blindages électromagnétiques qui sont réalisés en des matériaux conducteurs d'électricité.

Ainsi, le réflecteur 14 forme un premier blindage qui empêche le rayonnement électromagnétique émis par la lampe à décharge 12 de se propager vers l'intérieur du véhicule.

Le module d'amorçage haute tension 24 est enfermé dans un étui blindé 46.

Le ballast 18 est aussi enfermé dans un boîtier 48 blindé étanche aux impuretés et aux liquides.

Le faisceau de connexion 30 est entouré d'une enveloppe tubulaire blindée 50 qui est ici formée d'une tresse tubulaire souple tissée 50A de fils métalliques. A chacune de ses deux extrémités, l'enveloppe blindée 50 comporte une chemise 50B de tôle métallique pliée qui revêt les faces supérieure, inférieure, et latérales du support de chaque connecteur d'extrémité de sortie 34 et d'amorçage 38. La tresse 50A est en contact électrique avec les deux chemises 50B d'extrémité. Ainsi, l'enveloppe blindée 50 forme un blindage pour le faisceau de connexion 30 et ses deux connecteurs réciproques d'extrémité 34, 38.

Les différents éléments de blindage 14, 32, 34, 36 sont tous raccordés électriquement à un potentiel électrique commun de référence qui est ici formé par la borne négative "-" de la batterie 20. Plus particulièrement, le boîtier 48 du ballast 18 et l'enveloppe 50 sont raccordés électriquement au potentiel électrique commun de référence.

De manière connue et comme représenté à la figure 2, le boîtier 48 est raccordé électriquement à la borne négative "-" de la batterie 20 par l'intermédiaire d'une piste 52 de la carte à circuit imprimé 44 du ballast 18 qui s'étend depuis la fiche négative 28A raccordée au potentiel négatif "-" de la batterie 20 jusqu'à un pion vertical de contact 54 qui est réalisé venu de matière avec le boîtier 48.

De manière connue, le réflecteur 14, l'étui 46, l'enveloppe 50 et le boîtier 48 sont raccordés électriquement entre eux en série pour éviter les fluctuations locales de potentiel dans les différents blindages.

En d'autres termes, le boîtier 48 étant relié électriquement à la borne négative "-" de la batterie 20, l'enveloppe 50, l'étui 46 et le réflecteur 14 sont aussi connectés électriquement en série à ladite borne négative "-".

Cependant, lorsque le ballast 18 est agencé dans le véhicule automobile, il est soumis à de nombreuses sollicitations mécaniques et thermiques. Le boîtier 48 est donc réalisé en un matériau qui doit être non seulement conducteur d'électricité, mais aussi résistant aux contraintes mécaniques et thermiques propres aux projecteurs de véhicules automobiles. Le choix du matériau résistant du boîtier 48 est effectué au détriment de sa conductivité électrique. Le boîtier 48 présente donc une impédance non négligeable qui est susceptible de créer des tensions électriques dans les divers éléments de blindage raccordés en série.

Selon les enseignements de l'invention, pour améliorer les performances du blindage électromagnétique, le boîtier 48 et l'enveloppe 50 sont raccordés en parallèle à la borne négative "-" formant le potentiel de référence par l'intermédiaire d'un élément de contact 56 électrique comme représenté à la figure 2.

L'élément de contact 56 est réalisé en un matériau conducteur d'électricité présentant une meilleure conductivité électrique que le matériau utilisé pour réaliser le boîtier 48. L'élément de contact 56 est par exemple réalisé en un matériau comportant du cuivre, tel que du laiton.

Avantageusement, l'élément de contact 56 est réalisé en une seule pièce de manière à présenter une impédance la plus faible possible.

Dans un premier mode de réalisation de l'invention représenté à la figure 2, l'élément de contact 56 est agencé de manière à raccorder électriquement la fiche négative 28A du connecteur réciproque d'entrée 28 avec la chemise 50B qui recouvre le connecteur réciproque de sortie 34 du faisceau de connexion 30. L'élément de contact 56 est alors agencé à l'extérieur du boîtier 48. L'élément de contact 56 est par exemple formé par un fil conducteur d'électricité.

Avantageusement, les premiers moyens de connexion d'entrée 26 du ballast 18 sont agencés de manière adjacente aux deuxièmes moyens de connexion de sortie 32 de manière que le parcours de l'électricité dans l'élément de contact 56 soit le plus court possible afin de réduire au maximum l'impédance de l'élément de contact 56.

Selon une variante non représentée de l'invention, l'élément de contact 56 raccorde un tronçon intermédiaire du fil conducteur négatif 22A, ou directement la borne négative, avec la tresse souple 50A de l'enveloppe 50.

Selon un deuxième mode de réalisation de l'invention qui est représenté aux figures 3 à 5, les premiers et deuxièmes moyens de connexion 26, 32 comportent un bloc commun de connexion 58 mécanique qui est destiné à guider les connecteurs réciproques 28, 34 jusqu'à leur position connectée, ainsi qu'à participer à leur maintien mécanique dans leur position connectée.

Le bloc de connexion 58 est agencé dans une ouverture 60 réalisée dans une face transversale verticale arrière du boîtier 48, en vis-à-vis des portions de sortie et d'entrée du bord arrière de la carte à circuit imprimé 44.

Le bloc de connexion 58 mécanique se présente sous la forme d'un pavé globalement parallélépipédique rectangle qui est délimité verticalement par une face horizontale supérieure 62 et par une face horizontale inférieure 64, et qui est délimité transversalement par deux faces verticales latérales 66 d'extrémité.

Le bloc de connexion 58 est traversé longitudinalement d'un premier orifice d'entrée 68 et d'un deuxième orifice de sortie 70 qui font communiquer l'intérieur du boîtier 48 avec l'extérieur.

Les orifices 68, 70 sont agencés de manière adjacente transversalement l'un à côté de l'autre. Les orifices 68, 70 sont séparés entre eux par une cloison verticale longitudinale mitoyenne 72.

Le premier orifice d'entrée 68 débouche à l'intérieur du boîtier 48 sur la portion d'entrée de la carte à circuit imprimé 44. Le deuxième orifice de sortie 70 débouche à l'intérieur du boîtier 48 sur la portion de sortie de la carte à circuit imprimé 44.

Chaque connecteur réciproque d'entrée 28 et de sortie 34 est ainsi destiné à être inséré axialement dans l'orifice 68, 70 associé et ainsi guidé jusqu'à sa position connectée comme décrit précédemment.

L'orifice de sortie 70 présente un profil complémentaire du profil du support 42 du connecteur réciproque de sortie 34 du faisceau de connexion 30. Dans l'exemple représenté à la figure 3, les deux orifices 68, 70 présentent un profil rectangulaire.

Le connecteur réciproque de sortie 34 est ainsi maintenu dans sa position connectée transversalement et verticalement par les faces intérieures de l'orifice de sortie 70 de profil complémentaire.

Dans ce mode de réalisation de l'invention, l'élément de contact 56 est porté par le bloc de connexion 58. L'élément de contact 56 est plus particulièrement agencé de manière à raccorder électriquement le potentiel commun de référence à l'enveloppe 50 du faisceau de connexion 30 lorsque le connecteur réciproque d'entrée 28 et le connecteur réciproque de sortie 34 occupent simultanément leur position connectée.

L'élément de contact 56 est formé par un cavalier qui chevauche par l'extérieur la cloison mitoyenne 72.

A cet effet, la face supérieure 62 du bloc de connexion 58 est ajourée d'une fenêtre d'entrée 74 et d'une fenêtre de sortie 76 qui débouchent respectivement dans le premier orifice d'entrée 68 et dans le deuxième orifice de sortie 70.

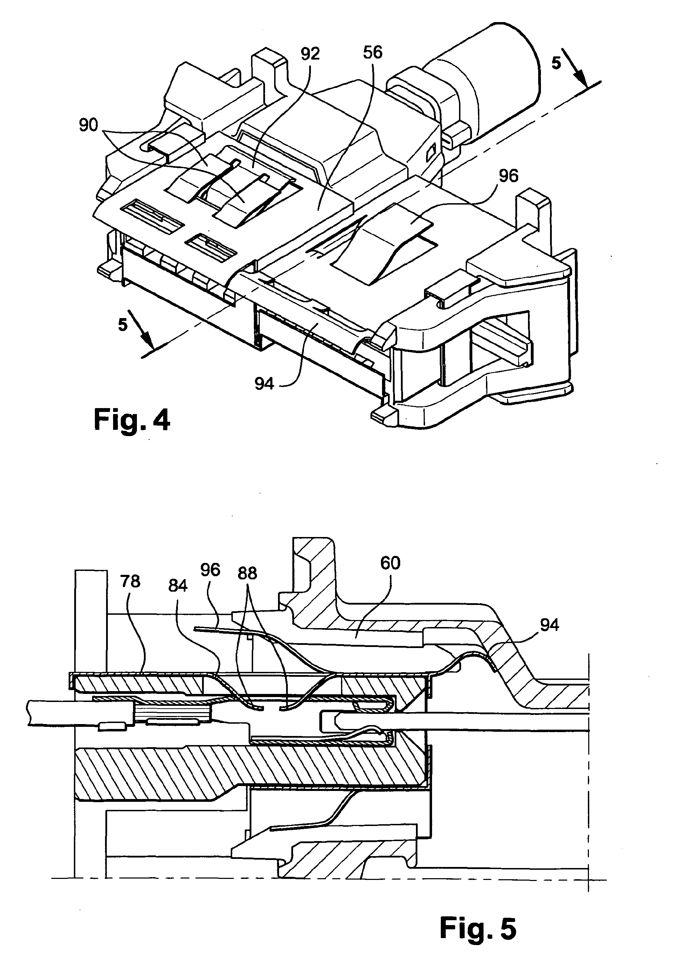

La première fenêtre d'entrée 74 débouche plus particulièrement au droit de la fiche négative 28A en position connectée du connecteur réciproque d'entrée 28 comme représenté à la figure 5.

En outre, dans le mode de réalisation représenté aux figures, le bloc de connexion 58 est équipé d'un blindage qui est réalisé venu de matière avec l'élément de contact 56.

Ainsi, deux coquilles horizontales supérieure 78 et inférieure 80 sont destinées à revêtir les faces extérieures 62, 64, 66 du bloc de connexion 58. A cet effet, la coquille supérieure 78, respectivement inférieure 80, présente une forme complémentaire de la forme de la face supérieure 62, respectivement inférieure 64, du bloc de connexion 58.

Les coquilles 78, 80 sont réalisées en une feuille d'un matériau conducteur d'électricité comportant par exemple du cuivre, tel que du laiton.

Au moins une des coquilles 78, 80 comporte deux ailes latérales 82 verticales qui sont destinées à être plaquées contre les faces latérales 66 du bloc de connexion 58 de manière que les deux coquilles 78, 80 soient en contact électrique l'une avec l'autre par l'intermédiaire des ailes 82.

Ledit matériau est aussi élastiquement déformable.

La coquille supérieure 78 comporte aussi deux ouvertures d'entrée 84 et de sortie 86 coïncidant avec chacune des fenêtres d'entrée 74 et de sortie 76. Les ouvertures d'entrée 84 et de sortie 86 sont ici formées par découpage de la feuille métallique.

L'ouverture d'entrée 84 comporte une première découpe formant une lamelle d'entrée 88 longitudinale avant qui s'étend longitudinalement vers l'arrière depuis un bord d'extrémité avant de l'ouverture d'entrée 84 jusqu'à une extrémité libre qui est agencé sensiblement au milieu de l'ouverture d'entrée 84.

L'ouverture d'entrée 84 comporte aussi une deuxième découpe formant une lamelle d'entrée 88 longitudinale arrière qui s'étend longitudinalement vers l'avant depuis un bord d'extrémité arrière de l'ouverture d'entrée 84 jusqu'à une extrémité libre qui est agencé sensiblement au milieu de l'ouverture d'entrée 84.

Les deux lamelles d'entrée 88 sont rabattues vers le bas en pénétrant à l'intérieur de la fenêtre d'entrée 74 de manière à être en contact électrique avec une face supérieure dénudée de la fiche négative 28A du connecteur réciproque d'entrée 28 lorsque cette dernière est en position connectée.

Plus particulièrement, les lamelles d'entrée 88 sont déformables élastiquement de manière que, lorsque la fiche négative 28A est en position connectée, l'extrémité libre des lamelles d'entrée 88 appuie élastiquement vers le bas contre la fiche négative 28A afin d'assurer un contact électrique permanent.

L'ouverture de sortie 86 de la coquille supérieure 78 est équipée de deux découpes formant des lamelles de sortie 90 de contact longitudinales qui s'étendent parallèlement vers l'arrière depuis un bord d'extrémité avant de l'ouverture de sortie 86 jusqu'à une extrémité libre qui est agencé au droit de l'ouverture de sortie 86. Les lamelles de sortie 90 sont destinées à être en contact avec une languette 92 portée par la chemise 50B du connecteur réciproque de sortie 34 lorsque ce dernier est en position connectée.

La languette 92 est réalisée en un matériau conducteur d'électricité et elle est connectée électriquement à la chemise 50B. Avantageusement, la languette 92 est réalisée venue de matière avec la chemise 50B du connecteur réciproque de sorti 34.

La languette 92 s'étend verticalement en saillie vers le haut depuis la face supérieure de la chemise 50B du connecteur réciproque de sortie 34. La languette 92 forme plus particulièrement une rampe montant vers le haut d'avant en arrière de manière à déformer élastiquement en flexion vers le haut les lamelles de sortie 90 lors de son insertion en position connectée. Les lamelles de sortie 90 sont ainsi plaquées élastiquement contre la rampe afin d'assurer un contact électrique permanent entre les lamelles de sortie 90 et la languette 92 tant que le connecteur réciproque de sortie 34 est dans sa position connectée.

Ainsi l'élément de contact 56 est formé par les lamelles d'entrée 88, les lamelles de sortie 90 et la portion de coquille supérieure 78 qui joints les lamelles d'entrée 88 et les lamelles de sortie 90. L'élément de contact 56 forme ainsi le cavalier qui chevauche la cloison mitoyenne 72.

Les deux coquilles 78, 80 interconnectées électriquement forment aussi le blindage électromagnétique de manière à empêcher des fuites de rayonnement électromagnétique par l'ouverture 60 du boîtier 48. Ledit blindage est réalisé venu de matière avec l'élément de contact 56 et il est connecté au potentiel de référence par l'intermédiaire des lamelles d'entrée 88.

Lors de la connexion du connecteur réciproque d'entrée 28, la fiche négative 28A est insérée longitudinalement dans l'orifice d'entrée 68 des moyens de connexion d'entrée 26 en vis-à-vis de la terminaison 52A de piste 52 associée. Lors du mouvement d'insertion, la fiche négative 28A entre en contact avec l'extrémité libre des lamelles d'entrées 88 qu'elle soulève élastiquement.

Ainsi, lorsque la fiche négative 28A occupe sa position connectée, les deux lamelles d'entrée 88 sont plaquée vers le bas contre la fiche négative 28A par leur force de rappel élastique. Les deux coquilles 78, 80 et le boîtier 48 sont ainsi en contact électrique avec la borne négative.

Puis, lorsque le connecteur réciproque de sortie 34 du faisceau de connexion 30 est inséré longitudinalement dans l'orifice de sortie 70 du bloc de connexion 58, la languette 92 supérieure vient en contact avec l'extrémité libre des lamelles de sortie 90. Lors du mouvement d'insertion longitudinal, l'extrémité libre des lamelles de sortie 90 est soulevée élastiquement vers le haut en glissant sur la rampe de la languette 92.

Lorsque le connecteur réciproque de sortie 34 est en position connectée, les lamelles de sortie 90 sont ainsi plaquées vers le bas contre la languette 92 par leur force de rappel élastique de manière à assurer un contact électrique permanent. La chemise 50B du connecteur réciproque de sortie 34 et l'enveloppe 50 sont ainsi connectées électriquement à la borne négative parallèlement au boîtier 48.

Selon une variante non représentée de l'invention, l'élément de contact 56 est formé par un cavalier qui est réalisé en une pièce indépendante. Dans ce cas, le bloc de connexion 58 peut ne pas comporter de blindage, ou comporte un blindage indépendant.

Avantageusement, comme représenté aux figures 4 et 5, les coquilles 78, 80 comportent aussi des points de contact avec le boîtier 48 de manière que l'élément de contact 56 raccorde électriquement le boîtier 48 au potentiel de référence parallèlement à l'enveloppe 50. La multiplication des points de contact permet d'assurer un potentiel électrique homogène sur toute la surface du boîtier 48.

A cet effet, une portion d'extrémité avant de la coquille supérieure 78 est conformée en une gouttière 94 convexe qui court transversalement le long du bord d'extrémité avant de manière à former une ligne de contact avec une face intérieure du boîtier 48.

En outre, la coquille supérieure 78 comporte encore une autre lamelle de contact 96, formée par une découpe de la coquille 78, qui est relevée verticalement vers le haut de manière à former un point de contact supplémentaire avec le boîtier 48.

Selon un troisième mode de réalisation de l'invention qui est représenté à la figure 6, le boîtier 48 est équipé d'un bloc de connexion 58 mécanique similaire à celui utilisé pour le deuxième mode de réalisation de l'invention.

Cependant, l'élément de contact 56 passe directement à travers la cloison mitoyenne 72 pour mettre en contact la fiche négative 28A avec la chemise 50B du connecteur réciproque de sortie 34. A cet effet, la cloison mitoyenne 72 est ajourée d'une fenêtre 98.

La fiche négative 28A est avantageusement agencée de manière à être interposée transversalement entre la cloison mitoyenne 72 et la fiche positive 28B.

L'élément de contact 56 est porté par le deuxième connecteur réciproque de sortie 34. Plus particulièrement, l'élément de contact 56 est formé par une lamelle qui s'étend transversalement en saillie par rapport à la face latérale de la chemise 50B du connecteur réciproque de sortie 34 qui est tournée vers la cloison mitoyenne 72.

L'élément de contact 56 comporte aussi une extrémité libre. L'élément de contact 56 est déformable élastiquement en flexion lors de l'introduction du connecteur réciproque de sortie 34 dans l'orifice de sortie 70 correspondant.

Afin de permettre l'insertion et le retrait du connecteur réciproque de sortie 34, l'élément de contact 56 présente la forme d'un "V" horizontal dont la pointe 100 est orientée transversalement vers la cloison mitoyenne 72. La première branche 56A est par exemple reliée mécaniquement à la chemise 50B par son extrémité opposée à la pointe 100, tandis que l'extrémité de l'autre branche 56B forme l'extrémité libre de l'élément de contact 56.

Lors de l'insertion connecteur de sortie 34 dans le bloc de connexion 58, la première branche 56A entre en contact avec le bord d'extrémité arrière de la cloison mitoyenne 72. Puis le mouvement d'insertion longitudinal du connecteur de sortie 34 continue de manière que l'élément de contact 56 soit fléchi élastiquement transversalement vers le connecteur de sortie 34 jusqu'à ce que la pointe 100 du "V" soit en contact avec la face interne de la cloison mitoyenne 72. La pointe 100 de l'élément de contact 56 est alors appuyée transversalement contre la paroi interne de la cloison mitoyenne 72 par sa force élastique de rappel.

Lorsque le connecteur de sortie 34 est en position connectée, la pointe 100 de l'élément de contact 56 est en vis-à-vis de la fenêtre 98 à l'intérieur de laquelle elle est rappelée élastiquement transversalement de manière que la pointe 100 soit en appui sur la fiche négative 28A du connecteur d'entrée 28 en position connectée.

Selon une variante non représentée de l'invention, l'élément de contact 56 est portée de manière symétrique par la fiche négative 28A du connecteur d'entrée 28.

Selon encore une autre variante non représentée de l'invention, l'élément de contact 56 est réalisé en une pièce indépendante qui est fixée dans la fenêtre 98 de la cloison mitoyenne 72 de manière à être en contact d'une part avec la chemise 50B et d'autre part avec la fiche négative 28A lorsque les connecteurs réciproques d'entrée 28 et de sortie 34 sont simultanément dans leur position connectée.

A cet effet, les deux extrémité transversales de l'élément de contact 56 comportent des lamelles d'extrémité transversale déformables élastiquement transversalement afin de permettre l'insertion de la fiche négative 28A et du connecteur de sortie 34, et afin d'assurer que les lamelles d'extrémité soit maintenues en permanence au contact électrique des connecteurs réciproques 28, 34 en position connectée par leur force de rappel élastique.

Selon un quatrième mode de réalisation de l'invention qui est représenté à la figure 7, la piste négative 52 des premiers moyens de connexion 26 comporte une double terminaison en forme de fourche qui est agencée sur la portion d'entrée de la carte 44.

Elle comporte ainsi la première terminaison 52A sur laquelle la fiche négative 28A est destinée à être connectée, et une deuxième terminaison dérivée 52B qui s'étend parallèlement à la première terminaison 52A. La deuxième terminaison dérivée 52B est interposée transversalement entre la première terminaison 52A et la cloison mitoyenne 72. Les terminaisons 52A, 52B sont ainsi connectées électriquement l'une à l'autre.

Dans ce mode de réalisation, l'élément de contact 56 est formé par un cavalier rigide qui chevauche un bord vertical d'extrémité longitudinale arrière 102 de la cloison mitoyenne 72.

L'élément de contact 56 comporte plus particulièrement un bras rigide 104 dont un premier tronçon 104A s'étend transversalement depuis la chemise 50B du connecteur de sortie 34 en arrière du bord d'extrémité arrière 102 de la cloison mitoyenne 72 lorsque le connecteur de sortie 34 est en position connectée. Le bras rigide 104 est relié mécaniquement à la chemise 50B par une liaison rigide.

Un tronçon d'extrémité libre 104B du bras 104 s'étend longitudinalement vers l'avant à l'intérieur du premier orifice d'entrée 68 du bloc 58, en formant un coude, par exemple à angle droit, avec le premier tronçon 104A.

L'élément de contact 56 est ainsi formé par le bras 104 en forme de "L" qui est dimensionné de manière à chevaucher par l'arrière le bord d'extrémité arrière 102 de la cloison mitoyenne 72 du bloc 58.

L'extrémité libre avant du deuxième tronçon 104B est conformé en une pince identique à la fiche négative 28A.

Ainsi, lorsque le connecteur de sortie 34 est en position connectée, l'élément de contact 56 chevauche le bord d'extrémité arrière 102 de la cloison mitoyenne 72 de manière que le deuxième tronçon 104B du bras 104 pince la terminaison dérivée 52B de la piste négative 52 de la carte 44. La chemise 50B du connecteur de sortie 34 est ainsi en contact électrique avec la terminaison dérivée 52B de la piste négative 52 par l'intermédiaire de l'élément de contact 56.

Lorsque la fiche négative 28A est dans sa position connectée, le potentiel négatif est acheminé par la première terminaison 52A jusqu'à l'embranchement avec la deuxième terminaison 52B, puis par la deuxième terminaison dérivée 52B jusqu'à l'élément de contact 56 qui est lui-même en contact électrique avec la chemise 50B du connecteur de sortie 34.

Avantageusement, la cloison mitoyenne 72 est longitudinalement plus courte que le bloc 58 de manière que le bord d'extrémité arrière 102 de la cloison mitoyenne 72 soit agencé à l'intérieur du bloc 58. Ainsi, lorsque le connecteur de sortie 34 est en position connectée, l'élément de contact 56 est agencé entièrement à l'intérieur du bloc 58. L'élément de contact 56 est ainsi protégé d'éventuels chocs mécaniques.

Bien sûr l'invention n'est pas limitée à la mise en oeuvre d'un seul des modes de réalisation précédemment décrit. Ainsi les différents modes de réalisation sont susceptibles d'être combinés afin que l'enveloppe de blindage soit connectée en de multiples points à la borne négative.

L'invention s'applique aussi à des moyens de connexion réalisés sous d'autres formes. Ainsi, l'invention s'applique aussi à un bloc de connexion mécanique comportant des fiches de contact électrique qui sont destinées à être connectées électriquement avec les fiches associées des connecteurs réciproques, d'une part, et avec une piste associée de la carte à circuit imprimé, d'autre part.

## Revendications

1. Dispositif d'alimentation électrique (16) pour une lampe à décharge (12) d'un projecteur (10) de véhicule automobile qui comporte :
- un module électronique (18) de conversion du courant électrique d'un source en courant électrique d'alimentation (20) de la lampe à décharge (12) ;
- un boîtier (48) qui renferme ledit module électronique (18) et qui est réalisé en/comporte un matériau conducteur d'électricité de manière à former un blindage électromagnétique ;
- un faisceau de connexion électrique (30) qui est destiné à raccorder électriquement le module électronique de conversion (18) avec la lampe à décharge (12) ;
- une enveloppe (50) réalisée en/comportant un matériau conducteur d'électricité qui entoure le faisceau de connexion (30) de manière à former un blindage électromagnétique;
- le boîtier (48) et l'enveloppe (50) étant raccordés électriquement à un potentiel électrique commun (-) de référence ;
**caractérisé en ce que** le boîtier (48) et l'enveloppe (50) sont raccordés en parallèle audit potentiel électrique commun de référence (-).

2. Dispositif (16) selon la revendication précédente, **caractérisé en ce que** l'enveloppe (50) est raccordée au potentiel électrique commun (-) par l'intermédiaire d'un élément de contact (56) réalisé en un matériau conducteur d'électricité présentant une meilleure conductivité électrique que le matériau utilisé pour réaliser le boîtier (48).

3. Dispositif (16) selon la revendication précédente, **caractérisé en ce que** l'élément de contact (56) est réalisé en un matériau comportant du cuivre.

4. Dispositif (16) selon l'une quelconque des revendications 2 ou 3, **caractérisé en ce que** le boîtier (48) comporte :
- des premiers moyens de connexion (26) dans lesquels un premier connecteur réciproque (28A) relié électriquement au potentiel de référence (-) est destiné à venir s'engager mécaniquement dans une position connectée ;
- et des deuxièmes moyens de connexion (32) dans lesquels un deuxième connecteur réciproque (34) du faisceau de connexion (30) est destiné à venir s'engager mécaniquement dans une position connectée, le deuxième connecteur réciproque étant entouré par l'enveloppe de blindage (50) du faisceau de connexion (30) ;
- les premiers moyens de connexion (26) étant agencés de manière adjacente aux deuxièmes moyens de connexion (32),
et **en ce qu'**un élément de contact (56) est agencé de manière à relier électriquement le potentiel commun de référence (-) à l'enveloppe (50) lorsque les premier (28A) et deuxième (34) connecteurs réciproques occupent simultanément leur position connectée.

5. Dispositif (16) selon la revendication précédente, **caractérisé en ce que** les premiers et deuxièmes moyens de connexion (26, 32) comportent un bloc commun (58) de connexion mécanique qui est agencé dans une ouverture (60) du boîtier (48), et **en ce que** l'élément de contact (56) est porté par le bloc de connexion (58).

6. Dispositif (16) selon la revendication précédente, **caractérisé en ce que** le bloc de connexion (58) comporte une cloison mitoyenne (72) qui sépare les premiers moyens de connexion (26) des deuxièmes moyens de connexion (32), et **en ce que** l'élément de contact (56) est formé par un cavalier qui chevauche la cloison mitoyenne (72).

7. Dispositif (16) selon la revendication précédente, **caractérisé en ce que** le bloc de connexion (58) est entouré d'un blindage électromagnétique (78, 80) qui est réalisé venu de matière avec l'élément de contact (56) de manière en empêcher des fuites de rayonnement électromagnétique par l'ouverture (60) du boîtier (48).

8. Dispositif (16) selon la revendication 6, **caractérisé en ce que** lesdits premiers moyens de connexion (26) comprennent une liaison électrique (52) avec au moins deux branches de connexion du module électronique (18), reliées électriquement entre elle, le premier connecteur réciproque (28A) relié électriquement au potentiel de référence (-) étant destiné à venir s'engager mécaniquement dans une position connectée à l'une (52A) de ces branches et ledit élément de contact (56) étant destiné à s'engager mécaniquement et en contact électrique avec l'autre branche de connexion (52B).

9. Dispositif (16) selon la revendication 8, **caractérisé en ce que** la liaison électrique est une piste électrique (52) d'une carte de circuit imprimé (44) du module électronique de conversion (18) et est en forme de fourche, chaque branche (52A; 52B) de la fourche constituant une branche de connexion dudit module électronique de conversion.

10. Dispositif (16) selon la revendication 4, **caractérisé en ce que** les premiers et deuxièmes moyens de connexion (26, 32) comportent un bloc commun (58) de connexion mécanique qui est agencé dans une ouverture (60) du boîtier (48), le bloc de connexion (58) comportant une cloison mitoyenne (72) qui sépare les premiers moyens de connexion (26) des deuxièmes moyens de connexion (32), et **en ce que** l'élément de contact (56) traverse ladite cloison mitoyenne (72).

11. Dispositif (16) selon la revendication précédente, **caractérisé en ce que** l'élément de contact (56) est porté par l'un des premier (28) ou deuxième (34) connecteurs réciproques.

## Patentansprüche

1. Stromversorgungsvorrichtung (16) für eine Entladungslampe (12) eines Kraftfahrzeugscheinwerfers (10), mit:
- einem elektronischen Modul (18) zur Umrichtung des elektrischen Stroms einer Stromversorgungsquelle (20) der Entladungslampe (12);
- einem Gehäuse (48), das das elektronische Modul (18) umschließt und aus einem Strom leitenden Werkstoff ausgeführt ist bzw. einen solchen umfasst, um eine elektromagnetische Abschirmung zu bilden;
- einem Anschlussstrang (30), der dazu bestimmt ist, das elektronische Umrichtmodul (18) mit der Entladungslampe (12) elektrisch zu verbinden;
- einer Hülle (50), die aus einem Strom leitenden Werkstoff ausgeführt ist bzw. einen solchen umfasst und den Anschlussstrang (30) solchermaßen umgibt, dass eine elektromagnetische Abschirmung gebildet wird;
- wobei das Gehäuse (48) und die Hülle (50) elektrisch an eine gemeinsame elektrische Bezugsspannung (-) angeschlossen sind;
**dadurch gekennzeichnet, dass** das Gehäuse (48) und die Hülle (50) parallel an die gemeinsame elektrische Bezugsspannung (-) angeschlossen sind.

2. Vorrichtung (16) nach dem vorhergehenden Anspruch,
**dadurch gekennzeichnet, dass** die Hülle (50) an die gemeinsame elektrische Spannung (-) mittels eines Kontaktelements (56) angeschlossen ist, das aus einem Strom leitenden Werkstoff ausgeführt ist, der eine bessere elektrische Leitfähigkeit aufweist als der zur Ausführung des Gehäuses (48) verwendete Werkstoff.

3. Vorrichtung (16) nach dem vorhergehenden Anspruch,
**dadurch gekennzeichnet, dass** das Kontaktelement (56) aus einem Werkstoff ausgeführt ist, der Kupfer umfasst.

4. Vorrichtung (16) nach einem der Ansprüche 2 oder 3,
**dadurch gekennzeichnet, dass** das Gehäuse (48) umfasst:
- erste Anschlussmittel (26), bei denen ein elektrisch mit der Bezugsspannung (-) verbundener erster wechselseitiger Verbinder (28A) dazu bestimmt ist, mechanisch eine Anschlussstellung einzunehmen;
- und zweite Anschlussmittel (32), bei denen ein zweiter wechselseitiger Verbinder (34) des Anschlussstrangs (30) dazu bestimmt ist, mechanisch eine Anschlussstellung einzunehmen, wobei der zweite wechselseitige Verbinder von der Abschirmhülle (50) des Anschlussstrangs (30) umgeben ist;
- wobei die ersten Anschlussmittel (26) zu den zweiten Anschlussmitteln (32) benachbart angeordnet sind,
und dass ein Kontaktelement (56) solchermaßen angeordnet ist, dass die gemeinsame Bezugsspannung (-) elektrisch mit der Hülle (50) verbunden ist, wenn der erste (28A) und der zweite (34) wechselseitige Verbinder gleichzeitig ihre Anschlussstellung einnehmen.

5. Vorrichtung (16) nach dem vorhergehenden Anspruch,
**dadurch gekennzeichnet, dass** die ersten und zweiten Anschlussmittel (26, 32) einen gemeinsamen mechanischen Anschlussblock (58) umfassen, der in einer Öffnung (60) des Gehäuses (48) angeordnet ist, und dass sich das Kontaktelement (56) an dem Anschlussblock (58) befindet.

6. Vorrichtung (16) nach dem vorhergehenden Anspruch,
**dadurch gekennzeichnet, dass** der Anschlussblock (58) eine Zwischenwand (72) aufweist, die die ersten Anschlussmittel (26) von den zweiten Anschlussmitteln (32) trennt, und dass das Kontaktelement (56) von einer Klammer gebildet ist, die die Zwischenwand (72) übergreift.

7. Vorrichtung (16) nach dem vorhergehenden Anspruch,
**dadurch gekennzeichnet, dass** der Anschlussblock (58) von einer elektromagnetischen Abschirmung (78, 80) umgeben ist, die mit dem Kontaktelement (56) einstückig solchermaßen ausgebildet ist, dass das Entweichen von elektromagnetischer Strahlung durch die Öffnung (60) des Gehäuses (48) verhindert ist.

8. Vorrichtung (16) nach Anspruch 6,
**dadurch gekennzeichnet, dass** die ersten Anschlussmittel (26) eine elektrische Verbindung (52) mit wenigstens zwei Anschlusszweigen des elektronischen Moduls (18) umfassen, die elektrisch miteinander verbunden sind, wobei der elektrisch mit der Bezugsspannung (-) verbundene erste wechselseitige Verbinder (28A) dazu bestimmt ist, an einem (52A) dieser Zweige mechanisch eine Anschlussstellung einzunehmen, und wobei das Kontaktelement (56) dazu bestimmt ist, mit dem anderen Anschlusszweig (52B) mechanisch und in elektrischem Kontakt verbunden zu werden.

9. Vorrichtung (16) nach Anspruch 8,
**dadurch gekennzeichnet, dass** die elektrische Verbindung eine Leiterbahn (52) einer Leiterplatte (44) des elektronischen Umrichtmoduls (18) ist und gabelförmig ausgebildet ist, wobei jeder Arm (52A; 52B) der Gabel einen Anschlusszweig des elektronischen Umrichtmoduls bildet.

10. Vorrichtung (16) nach Anspruch 4,
**dadurch gekennzeichnet, dass** die ersten und zweiten Anschlussmittel (26, 32) einen gemeinsamen mechanischen Anschlussblock (58) umfassen, der in einer Öffnung (60) des Gehäuses (48) angeordnet ist, wobei der Anschlussblock (58) eine Zwischenwand (72) aufweist, die die ersten Anschlussmittel (26) von den zweiten Anschlussmitteln (32) trennt, und dass das Kontaktelement (56) die Zwischenwand (72) durchquert.

11. Vorrichtung (16) nach dem vorhergehenden Anspruch,
**dadurch gekennzeichnet, dass** sich das Kontaktelement (56) an dem ersten (28) oder dem zweiten (34) wechselseitigen Verbinder befindet.

## Claims

1. Electrical supply device (16) for a discharge lamp (12) of a motor vehicle headlight (10) which comprises:
- an electronic module (18) for conversion of the electric current of an electric current supply source (20) of the discharge lamp (12);
- a housing (48) which contains the said electronic module (18), and is made of / comprises a material which conducts electricity, such as to form electromagnetic shielding;
- an electrical connection bundle (30), which is designed to connect the electronic conversion module (18) electrically to the discharge lamp (12);
- an envelope (50) which is made of / comprises a material which conducts electricity, and surrounds the connection bundle (30) such as to form electromagnetic shielding;
- the housing (48) and the envelope (50) being connected electrically to a common electric reference potential (-);
**characterised in that** the housing (48) and the envelope (50) are connected in parallel to the said common electric reference potential (-).

2. Device (16) according to the preceding claim, **characterised in that** the envelope (50) is connected to the common electric potential (-) by means of a contact element (56) made of a material which conducts electricity, and has better electric conductivity than the material used to produce the housing (48).

3. Device (16) according to the preceding claim, **characterised in that** the contact element (56) is made of a material comprising copper.

4. Device (16) according to either of claims 2 or 3, **characterised in that** the housing (48) comprises:
- first connection means (26), in which a first reciprocal connector (28A) connected electrically to the reference potential (-) is designed to be engaged mechanically in a connected position; and
- second connection means (32), in which a second reciprocal connector (34) of the connection bundle (30) is designed to be engaged mechanically in a connected position, the second reciprocal connector being surrounded by the shielding envelope (50) of the connection bundle (30);
- the first connection means (26) being arranged in a manner adjacent to the second connection means (32);
and **in that** a contact element (56) is arranged such as to connect the common reference potential (-) electrically to the envelope (50), when the first (28A) and second (34) reciprocal connectors occupy their connected position simultaneously.

5. Device (16) according to the preceding claim, **characterised in that** the first and second connection means (26, 32) comprise a common mechanical connection block (58) which is arranged in an opening (60) in the housing (48), and **in that** the contact element (56) is supported by the connection block (58).

6. Device (16) according to the preceding claim, **characterised in that** the connection block (58) comprises a dividing wall (72) which separates the first connection means (26) from the second connection means (32), and **in that** the contact element (56) is formed by a link which straddles the dividing wall (72).

7. Device (16) according to the preceding claim, **characterised in that** the connection block (58) is surrounded by electromagnetic shielding (78, 80) which is integral with the contact element (56), such as to prevent electromagnetic radiation from leaking through the opening (60) in the housing (48).

8. Device (16) according to claim 6, **characterised in that** the said first connection means (26) comprise an electrical connection (52) with at least two connection branches of the electronic module (18) which are connected electrically to one another, the first reciprocal connector (28A) which is connected electrically to the reference potential (-) being designed to be engaged mechanically, in a connected position, to one (52A) of these branches, and the said contact element (56) being designed to be engaged mechanically, and in electric contact with, the other connection branch (52B).

9. Device (16) according to claim 8, **characterised in that** the electric connection is an electric track (52) of a printed circuit board (44) of the electronic conversion module (18), and is in the form of a fork, each branch (52A; 52B) of the fork constituting a connection branch of the said electronic conversion module.

10. Device (16) according to claim 4, **characterised in that** the first and second connection means (26, 32) comprise a common mechanical connection block (58), which is arranged in an opening (60) in the housing (48), the connection block (58) comprising a dividing wall (72) which separates the first connection means (26) from the second connection means (32), and **in that** the contact element (56) passes through the said dividing wall (72).

11. Device (16) according to the preceding claim, **characterised in that** the contact element (56) is supported by one of the first (28) or second (34) reciprocal connectors.
